# EUROPEAN PATENT APPLICATION

(11) **EP 4 064 363 A1**
(43) Date of publication of application: **28.09.2022**
(21) Application number: 21164635.1
(22) Date of filing: 24.03.2021
(51) Int. Cl.: H01L 29/51, H01L 29/40, H01L 21/331, H01L 29/739

(54) **SEMICONDUCTOR DEVICE WITH AN INSULATED GATE, METHOD FOR MANUFACTURING THE SAME AND POWER MODULE COMPRISING THE SAME**

(71) Applicant: Hitachi Energy Switzerland AG, 5400 Baden (CH)
(72) Inventor: SALVATORE, Giovanni, 34170 Gorizia (IT); DE-MICHIELIS, Luca, 5000 Aarau (CH); VITALE, Wolfgang Amadeus, 5000 Aarau (CH)
(74) Representative: Epping - Hermann - Fischer

(57) **Abstract**

The disclosure relates to a semiconductor device with an insulated gate, comprising:
- a gate contact (9), wherein the gate contact (9) is formed as a trench gate structure (11, 33); and
- a semiconductor body (2, 31), on which the gate contact (9) is arranged;
wherein the gate contact (9) is at least partially embedded in a non-linear dielectric layer (10, 34).

The disclosure further relates to a method for manufacturing a semiconductor device with an insulated gate, and a power module comprising a semiconductor device with an insulated gate.

## Description

The present disclosure relates to a semiconductor device with an insulated gate with a gate contact and a semiconductor body. The present disclosure further relates to a method for manufacturing such semiconductor device with an insulated gate and a power module comprising such semiconductor device with an insulated gate.

Semiconductor devices, such as for example insulated-gate bipolar transistors, IGBTs, metal-insulating-semiconductor field-effect transistors, MISFETs or metal-oxide-semiconductor field-effect transistors, MOSFETs, are well known in the art. An IGBT, MISFET or MOSFET is a three-terminal power semiconductor device primarily used as an electronic switch which, as it was developed, came to combine high efficiency and fast switching. Over time, however, after many switching cycles, the characteristics of such a MOSFET or IGBT can be affected, for example by aging and/or electrical wear.

The prior art thus gives room for improvements with that regard. Accordingly, it would be favorable, for example, to improve semiconductor devices with an insulated gate to have a higher durability.

Embodiments of the disclosure address the above shortcomings in the art in whole or in part, as further explained below. These are addressed at least in part by providing an improved semiconductor device with an insulated gate, an improved method for manufacturing a semiconductor device with an insulated gate and a power module comprising such semiconductor device with an insulated gate, according to the attached independent claims, which solve or reduce the above mentioned issues.

According to a first aspect, a semiconductor device with an insulated gate comprises a gate contact. The gate contact is formed as a trench gate structure. The semiconductor device further comprises a semiconductor body, on which the gate contact is arranged. The gate contact is at least partially embedded in a non-linear dielectric layer.

An advantage of the semiconductor device disclosed herein is that a risk of hot carrier injection into a gate insulating layer, which might cause the critical conditions for avalanche generation in the semiconductor body of such semiconductor device being met, can be reduced or avoided. Such avalanche generation can occur in a conventional semiconductor device with an insulated gate, for example during turn-off switching events, which are characterized by high voltage drop (dV/dt) conditions and large currents.

The above-mentioned hot carrier injection can lead to oxide degradation effects in the gate insulating layer of a conventional semiconductor device. After repetitive switching cycles, it can affect the switching characteristics of the device itself.

The semiconductor device according to the first aspect, using non-linear dielectrics in the semiconductor device, can leverage the capacitance-voltage dielectric behavior of such gate insulating layer in combination with the voltage gradient along the gate structure. A reliability of such semiconductor device is thereby improved.

Moreover, further advantages may be that also problems relating to the trench formation of such trench gate structure may be mitigated or reduced, and a more effective depletion and distribution of a field between trenches for narrow pitch devices may be achieved.

The semiconductor device may be, for example, an insulated-gate bipolar transistor, IGBT, a metal-insulating-semiconductor field-effect transistor, MISFET, or a metal-oxide-semiconductor field-effect transistor, MOSFET. An IGBT with such gate contact is also known as a trench IGBT. A MOSFET with such gate contact is also known as a trench MOSFET. Such trench gate structure has a lateral side wall, along which the gate contact penetrates into the semiconductor body, and a bottom wall, which lies at an end of the trench gate structure inside the semiconductor body. The bottom wall may be substantially or completely perpendicular to the side wall. The non-linear dielectric layer may be arranged along the side wall and the bottom wall, at least partially insulating the gate contact from the semiconductor body, which at least partially surrounds the gate contact.

The semiconductor body, on which the gate contact is arranged, comprises p and n layers of the semiconductor device. Those layers may be arranged, for example, according to conventional semiconductor devices or any kind of future semiconductor devices which are to be developed.

The gate contact being at least partially embedded in the non-linear dielectric layer means that, in at least some part, the non-linear dielectric layer covers the gate contact. The gate contact and the non-linear dielectric layer may be adjacent and may share a common surface. The non-linear dielectric layer may be arranged along the entire trench structure, such that the gate contact does not have direct contact with the semiconductor body. Thus, the gate contact may be separated from the semiconductor body by the non-linear dielectric layer.

In the non-linear dielectric layer, the electric dipolar moment per unit volume may have a non-linear dependence on an electric field in the semiconductor device. With other words, the non-linear dielectric layer exhibits a charge-voltage dependence that is not linear.

The semiconductor device with the insulated gate may be a silicon based semiconductor device such as, for example, a silicon trench IGBT. However, it may also be a silicon carbide (SiC) semiconductor device such as, for example, an SiC trench MOSFET or an SiC IGBT.

According to at least one embodiment, the non-linear dielectric layer may have higher capacitive coupling properties in a region of the lateral side wall than in a region of the bottom wall of the trench gate structure. Herein, the region of the lateral side wall includes the part of the non-linear dielectric layer which lies adjacent to the side wall and the region of the bottom wall includes the part of the non-linear dielectric layer which lies adjacent to the bottom wall.

A semiconductor device that is designed such that the non-linear dielectric layer has higher capacitive coupling properties in the region of the side wall than in the region of the bottom wall has the advantage that characteristics of the non-linear dielectric layer are used in the semiconductor device.

In the semiconductor body, adjacent to at least one side of the side wall of the trench gate structure, a channel region is created during a switching of the semiconductor device. The non-linear dielectric layer described herein provides a higher capacitive coupling in the region of the side wall, which is adjacent to this channel region in the semiconductor body, than in the region of the bottom wall of the trench gate structure.

In the region of the side wall, a respectively lower voltage drop occurs during a switching of the semiconductor device, in general, than in a region of the bottom wall of the trench gate structure. This mitigates the risk of hot carrier injection in the region at the bottom wall, in which the higher voltage drop occurs. With other words, the semiconductor device according to such embodiment has a self-limiting robustness to dynamic charge carrier avalanches in the region at the bottom wall but at the same time higher capacitive coupling properties in the region at the side wall, which lies adjacent to the channel region. Therefore, a gate capacitance required for electrostatic control in the region of the side wall may be provided to a sufficient extent, without reducing a thickness of the insulating layer to such an extent that it could not conveniently be processed or could be exposed to unacceptable leakage current.

In order to improve those characteristics of the non-linear dielectric, a design of the semiconductor device and the gate dielectric material may be accordingly adapted. For example, a composition of the gate dielectric material, an operation temperature, a thickness of the non-linear dielectric layer, etc. may be adjusted.

According to at least one embodiment, the non-linear dielectric layer, by which the gate contact is at least partially embedded, comprises a material which is doped with at least one further material.

Thereby, the characteristics of the linear dielectric may be adjusted to exhibit a ferroelectric behavior.

Such doped material for the non-linear dielectric layer is advantageous in that such material as dielectric layer may overcome problems caused by thermodynamic incompatibilities of other ferroelectric materials at use as gate dielectrics in semiconductor devices.

According to at least one embodiment, a Curie temperature of the non-linear dielectric layer is lower than an operating temperature of the semiconductor device.

In this context, the Curie temperature of the non-linear dielectric layer is the temperature, at which a phase transition between ferroelectricity and paraelectricity occurs in the non-linear dielectric layer. A material with ferroelectric properties at lower temperatures has paraelectric properties above its specific Curie temperature. The operating temperature refers, in this case, to an operating temperature during an intended use of the semiconductor device, which describes the use of said semiconductor device in an environment, e.g. a certain electronic device, surrounding temperature etc., for which it is intended to be used. Further, the intended use in this context relates to a use of said semiconductor device in an environment and e.g. an extent of switching, which is substantially normal for the use for which it is intended without being severely damaged.

An advantage of the Curie temperature of the non-linear dielectric layer being lower than the operating temperature of the semiconductor device is that, in such operation, the non-linear dielectric layer has paraelectric properties. With paraelectric properties, the dependence between induced polarization (P) and an external electric field (E) does not have the hysteretic behavior of the P-E dependence of a ferroelectric material. Using an operation temperature, at which the non-linear dielectric layer has a paraelectric behavior (i.e. no hysteretic P-E dependence) has the advantage that obstacles arising from a time-dependence of the polarization in a ferroelectric material, for example due to a threshold voltage drift over time, which may lead to long-term reliability issues or arising during a switching of a semiconductor device may be reduced or overcome.

According to a second aspect, a method for manufacturing a semiconductor device with an insulated gate comprises the steps:
- providing a semiconductor wafer for the semiconductor device;
- arranging a gate contact on the semiconductor wafer, wherein the gate contact is formed as a trench gate structure and the gate contact is at least partially embedded in a non-linear dielectric layer.

Embodiments and advantages disclosed and discussed with respect to the first aspect apply equally to the second aspect.

An advantage of the method according to the second aspect is that a semiconductor device with the above-mentioned advantages can be formed in an efficient and straightforward way. According to said method, an oxide insulation layer, i.e. the non-linear dielectric layer, with higher capacitive coupling in the region at the side wall and self-limiting robustness to dynamic avalanche in the region at the bottom wall of the trench may be formed with a single processing step.

According to a third aspect, a power module comprises a semiconductor device with an insulated gate according to the first aspect.

Embodiments and advantages of the first and second aspect apply equally to the third aspect and vice versa.

The semiconductor device in any of the above-discussed aspects may be, for example, an insulated-gate bipolar transistor, IGBT, such as for example a silicon trench IGBT or a silicon carbide trench IGBT, or a silicon carbide trench metal-oxide-semiconductor field-effect transistor, MOSFET. Further embodiments and advantages are disclosed in the attached figures and the description thereof. In the figures, the disclosure is explained in detail with respect to an insulated-gate bipolar transistor. This example, however, shall not limit the scope of the disclosure. The disclosed features could equally be applied to any other kind of semiconductor device.

In the figures:
- Figure 1: shows a schematic cross sectional view of a part of an insulated-gate bipolar transistor, IGBT, according to one embodiment of the disclosure;
- Figure 2: shows diagrams of capacitance-voltage curves of a linear and a non-linear dielectric;
- Figure 3: shows diagrams of dielectric constant dependence on an external field of a ferroelectric and a paraelectric material;
- Figure 4: shows characteristics of a conventional IGBT during a switching event;
- Figure 5: shows characteristics of an IGBT according to one embodiment of the disclosure during a switching event;
- Figure 6: shows polarization and dielectric constants of different materials and their dependence on an applied electric field;
- Figure 7: shows a flowchart of a method for manufacturing an IGBT according to one embodiment of the disclosure; and
- Figure 8: shows a power module with multiple IGBTs according to one embodiment of the disclosure.

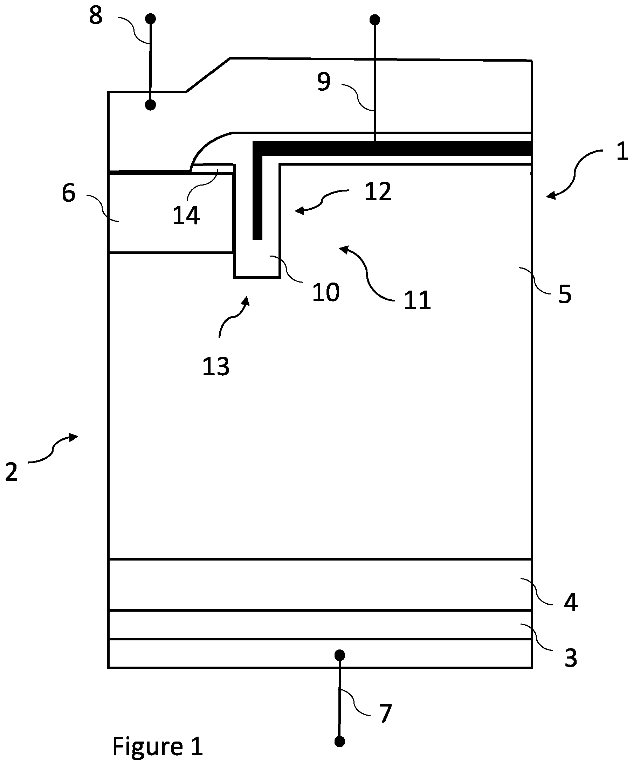

Figure 1 shows a schematic cross sectional view of a part of an insulated-gate bipolar transistor, IGBT, 1 according to one embodiment of the disclosure. The IGBT 1 comprises a semiconductor body 2 with different layers. From bottom to top, the semiconductor body 2 comprises a collector layer 3, above the collector layer 3 an optional buffer layer 4, above the buffer layer 4 a drift layer 5. The drift layer 5 is significantly thicker than each of the collector layer 3 and the buffer layer 4. In the embodiment shown herein, the drift layer 5 is between 5 to 10 times as thick as, for example, the buffer layer 4. On top of the drift layer 5, a p-well 6 is arranged, which only extends along a part of a surface of the drift layer 5. Above the p-well 6, an n-source region 14 is arranged.

On a bottom end of the semiconductor body 2, below the collector layer 3, a collector contact 7 is arranged. On a top end of the semiconductor body 2, an emitter contact 8 is arranged. The emitter contact 8 partially contacts the p-well 6.

Between the drift layer 5 and the emitter contact 8, a gate contact 9 is arranged. The gate contact 9 is embedded in a non-linear dielectric layer 10. The non-linear dielectric layer 10 surrounds the gate contact 9 such that the gate contact 9 is spatially distanced and electrically insulated from the emitter contact 8 and any doped layer like the drift layer 5. The non-linear dielectric layer 10 further spatially distances the gate contact 9 from the p well 6, which is arranged adjacent to the non-linear dielectric layer 10. Thereby, the non-linear dielectric layer 10 electrically insulates the gate contact 9 from the semiconductor body 2 and the emitter contact 8.

The gate contact 9 is formed as a trench gate structure 11. This means, the gate contact 9 has a first part, extending in this embodiment in parallel to a main extension surface of the drift layer 5. Moreover, the gate contact 9 has a second part, which penetrates the semiconductor body 2, on which the gate contact 9 is arranged. The first part and the second part of the gate contact 9 stand perpendicular to each other in the embodiment as shown in Figure 1. Such IGBT 1 is also called a trench IGBT.

The trench gate structure 11 has a lateral side wall 12, along which the trench gate structure 11 extends into the semiconductor body 2, and a bottom wall 13, which lies at an end of the trench gate structure 11 inside the semiconductor body 2. The bottom wall 13 in this embodiment is perpendicular to the lateral side wall 12. The bottom wall 13 in this case is parallel to a main extension area of the semiconductor body 2 and the lateral side wall 12 in this case is perpendicular to the main extension area of the semiconductor body 2. During a switching of the IGBT 1, a channel region is created in the semiconductor body 2 on a side of the lateral side wall 12, which faces the emitter contact 8. Alternatively or additionally, there could also be an emitter contact on the other side of the trench gate structure 11, in which case an alternative or additional channel region would be created inside the semiconductor body 2 during the switching on the other side of the trench gate structure 11. The non-linear dielectric layer 10 is arranged along the entire side wall 12 and the bottom wall 13 of the trench gate structure 11, thereby insulating the gate contact 9 from the semiconductor body 2.

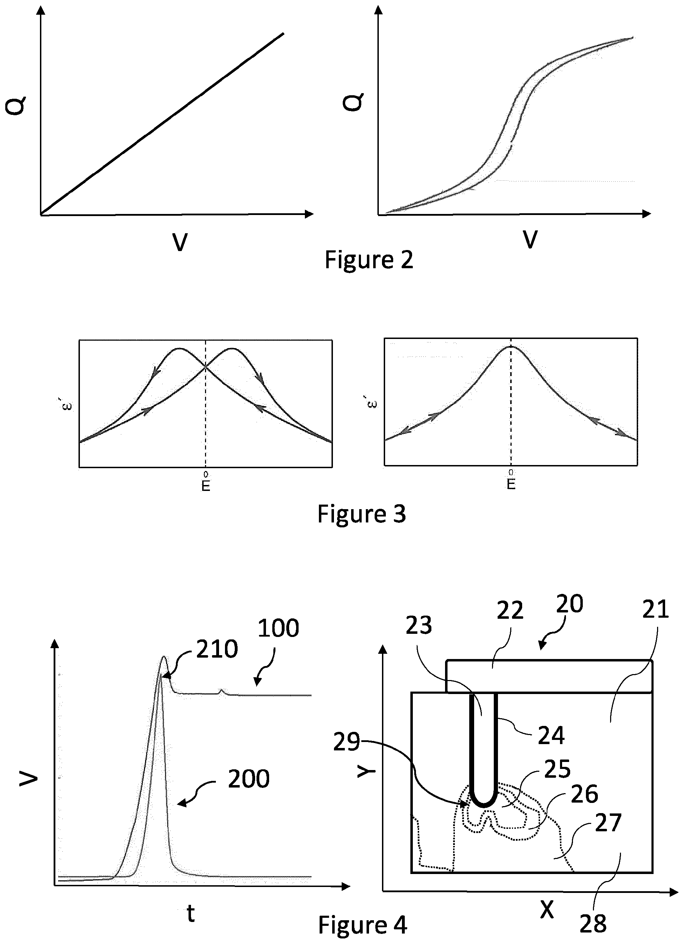

The non-linear dielectric layer 10 is made of, in this case, a material with non-linear dielectric characteristics. The electric dipolar moment per unit volume in this material has a non-linear dependence on an electric field being present in the IGBT 1. Such behavior is shown, for example, in the curve of Figure 2, right diagram. In this diagram, a capacitance-voltage curve for a non-linear dielectric is shown. The capacitance of the material changes depending on an external field. In comparison to that, the left diagram of Figure 2 shows the capacitive properties of a linear dielectric material, which exhibits a charge-voltage (Q-V) curve that is a straight line. The slope of this curve indicates the capacitance of the material.

Such S-shaped non-linear dielectric behavior is typical for ferroelectric and paraelectric materials, whose dielectric constant dependencies are shown in the diagrams of Figure 3. The left diagram shows a dielectric dependence on an external electric field of a ferroelectric non-linear dielectric material and the right diagram of Figure 3 shows a dielectric dependence on an external electric field of a paraelectric non-linear dielectric material.

As can be seen in both curves of Figure 3, the dielectric constant changes with the electric field. This behavior is advantageous for the non-linear dielectric layer 10 of the IGBT 1 in Figure 1, because in regions of the trench gate structure 11, in which a higher electric field occurs, i.e. regions with a higher voltage drop, a lower capacitive coupling is achieved. This can reduce or avoid the risk of hot carrier injections during switching of an IGBT such as the IGBT 1 of Figure 1. By reducing or avoiding the risk of hot carrier injection in the IGBT 1 with the non-linear dielectric layer 10, a durability of the IGBT 1 is improved, since thereby oxide degradation effects of a conventional insulating layer are reduced, which may occur after repetitive switching cycles. Such degradation effects may affect the switching characteristics of the IGBT and avoiding those, therefore, enhances its durability.

Some characteristics of a conventional IGBT during a switching event are shown in Figure 4. The diagram on the left in Figure 4 shows an example of a turn-off waveform under normal switching conditions for a conventional IGBT device. A first curve 100 shows the voltage over time of a collector-emitter voltage during such turn-off switching, a second curve 200 shows a carrier avalanche generation over time during such turn-off switching, caused by the high voltage drop (dV/dt) of the collector-emitter voltage of the first curve 100. As can be seen in said diagram, a significant avalanche generation occurred in this case.

A region of the avalanche generation is pictured in the right diagram of Figure 4, which shows a part of a conventional IGBT 20. In said right diagram of Figure 4, a semiconductor body 21, a passivation layer 22, a trench gate structure 23 and an insulating layer 24 of the conventional IGBT 20 are shown.

Moreover, impact ionization in the semiconductor body 21 during a peak 210 of the avalanche generation (i.e. second curve 200 of the left diagram of Figure 4) is pictured in this right diagram of Figure 4. As can be seen here, there is a first region 25 with highest impact ionization, a second region 26 with high impact ionization, a third region 27 with average impact ionization, and the remaining region 28 in the semiconductor body 21 has a low impact ionization. This regional picturing of impact ionization is obviously simplified for an easier explanation. What can be learned from this Figure is, that the highest impact ionization, i.e. the avalanche generation occurs in a region of a bottom wall 29 of the trench gate structure 23.

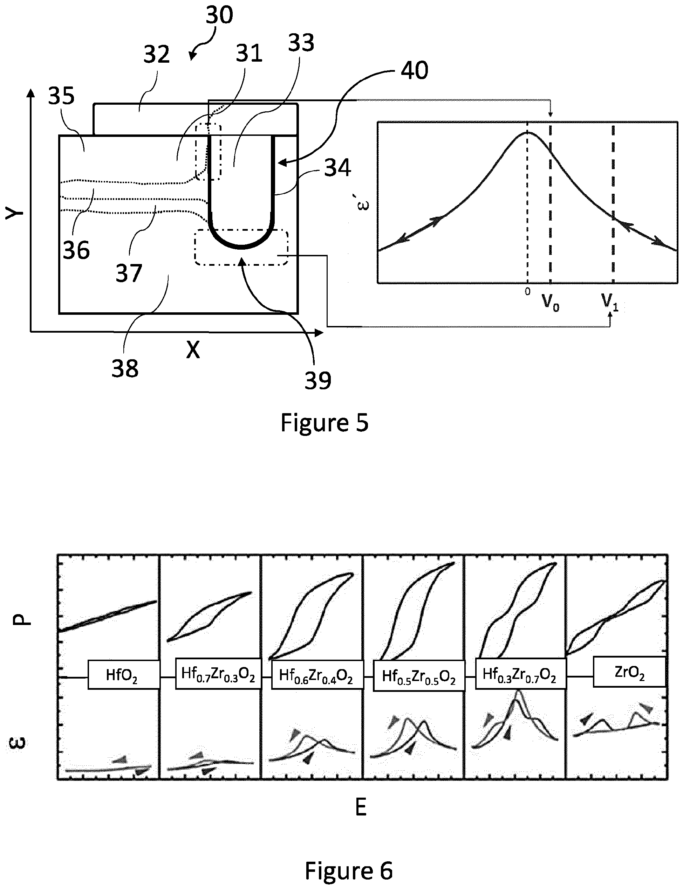

Figure 5 shows characteristics of an IGBT 30 according to one embodiment of the disclosure during a turn-off switching. The diagram on the left of Figure 5 shows a part of the IGBT 30 for easy comparison to the conventional IGBT 20 of Figure 4. The IGBT 30 according to Figure 5 also shows a semiconductor body 31, a passivation layer 32, a trench gate structure 33 and, in this case, a non-linear dielectric layer 34 of the IGBT 30. The arrangement shown herein slightly differs from that of the IGBT 1 shown in Figure 1, however, their features with respect to this disclosure may be interchangeable.

The left diagram of Figure 5 shows a distribution of an electrostatic potential in the IGBT 30. In a first region 35 a lowest electrostatic potential, in a second region 36 a low electrostatic potential, in a third region 37 an average electrostatic potential and in a remaining region 38 a high electrostatic potential occurs. As can be seen here, in a region at a bottom wall 39 of the trench gate structure 33, the high electrostatic potential, i.e. high voltage drop, occurs. In a part of a region of a lateral side wall 40, the lowest electrostatic potential, i.e. lowest voltage drop, occurs.

As further can be seen from the diagram on the right of Figure 5, which shows a dielectric dependence on the voltage potential in the non-linear dielectric layer 34, higher capacitive coupling in the area with the lowest voltage drop and smaller coupling in the area with high voltage drop occurs as consequence of the dielectric constant modulation through the field along the trench gate structure 33.

This mitigates the risk of hot carrier injection in the region at the bottom wall 39, in which the high voltage drop occurs. With other words, the IGBT 30 according to such embodiment has a self-limiting robustness to dynamic charge carrier avalanches in the region at the bottom wall 39, but at the same time higher capacitive coupling properties in the region at the lateral side wall 40 with the lowest voltage drop.

In order to improve those characteristics of the non-linear dielectric layers 10, 34, a design of the IGBT and the gate dielectric material may be accordingly adapted. For example, a composition of the gate dielectric material, an operation temperature, a thickness of the non-linear dielectric layer, etc. may be adjusted.

A thickness of the non-linear dielectric layers 10, 34 may be, for example, between 1 and 500 nanometers. A thinner dielectric layer can be advantageous for scaling rules on the gate capacitance. A thicker dielectric layer may be easier and/or cheaper to manufacture and may reduce loss related to gate-emitter leakage.

As a material for the non-linear dielectric layer 10, 34, in which the gate contact 9 is at least partially embedded, a material with substantially linear dielectric behavior may be used, which is doped with at least one second material to render it ferroelectric.

An example thereof is shown in Figure 6. Figure 6 shows polarization hysteresis loops in an applied electric field and dielectric constants depending on an applied electric field in thin films of a hafnium dioxide (HfO₂) - zirconium dioxide (ZrO₂) system. HfO₂ has a substantially linear dielectric behavior. By doping the HfO₂ with ZrO₂, a ferroelectric behavior is achieved. Alternatively, the HfO₂ may also be doped with silicon (Si). Such materials overcome problems caused by thermodynamic incompatibilities of other ferroelectric materials at use as gate dielectrics in semiconductor devices.

A further improvement of the non-linear dielectric layers 10, 34 may be achieved by designing the IGBT 1, 30 to have a non-linear dielectric layer 10, 34 with a Curie temperature that is lower than an operating temperature of the semiconductor device.

At the Curie temperature of the non-linear dielectric layer 10, 34 a phase transition between ferroelectricity and paraelectricity occurs. A material with ferroelectric properties at lower temperatures has paraelectric properties above said Curie temperature.

In such operation, the non-linear dielectric layer has paraelectric properties. With paraelectric properties, the dependence between induced polarization (P) and an external electric field (E) does not have the hysteretic behavior of the P-E dependence of a ferroelectric material. Using an operating temperature, at which the non-linear dielectric layer has a paraelectric behavior (i.e. no hysteretic P-E dependence) has the advantage that obstacles arising from a time-dependence of the polarization in a ferroelectric material may be overcome or reduced during a switching of an IGBT. The Curie temperature of the material can be tailored within a certain range by changing the composition of the materials. The addition of a buffer oxide layer may also influence such parameter.

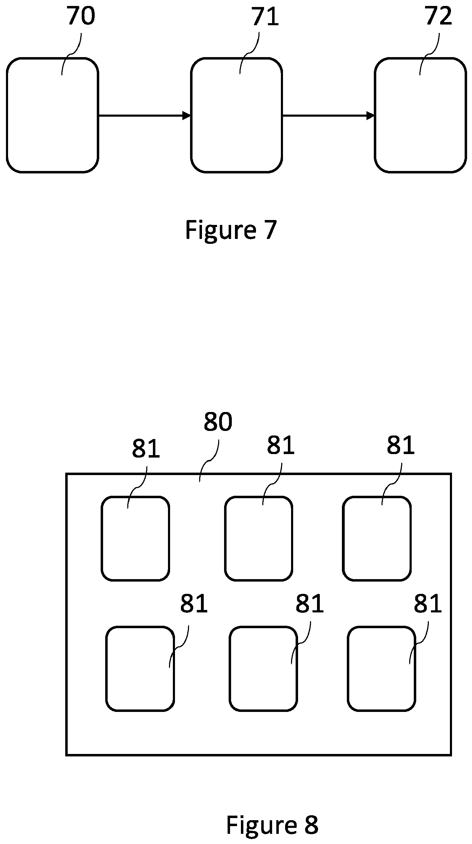

Figure 7 shows a flowchart of a method for manufacturing an IGBT according to one embodiment of the disclosure. In a first step 70, a semiconductor wafer for the IGBT is provided. In a second step 71, a material with linear dielectric behavior is doped with at least one further material, and a non-linear dielectric layer is formed with said doped material. In a third step 72, a gate contact is arranged on the semiconductor wafer, wherein the gate contact is formed as a trench gate structure and at least partially embedded in the non-linear dielectric layer. The semiconductor wafer may be processed according to known processing steps, directly after the first step 70 or after any of the second or third step 71, 72, to receive a semiconductor body for the IGBT. With said method, for example the IGBT 1 or the IGBT 30 according to Figures 1 or 5 may be manufactured.

Figure 8 shows a power module 80 with multiple IGBTs 81 according to one embodiment of the disclosure. The IGBTs 81 are, for example, such as disclosed and described with respect to Figure 1. Such power module 80 may of course comprise further devices, such as for example power semiconductor diodes, which are not shown or further explained herein and may correspond to known additional devices of such power module 80. The power module 80 may be designed to be used for voltages of 0.5 kilovolt and higher.

The IGBTs 1, 30, 81 shown herein are exemplary. The non-linear dielectric layer 10, 34, which at least partially insulates the gate contact 9 from the semiconductor bodies 2, 31, may also be applied to any other kind of IGBT or other transistor.

### List of reference signs

- 1, 30, 81: insulated-gate bipolar transistor, IGBT
- 2, 21, 31: semiconductor body
- 3: collector layer
- 4: buffer layer
- 5: drift layer
- 6: p-well
- 7: collector contact
- 8: emitter contact
- 9: gate contact
- 10, 34: non-linear dielectric layer
- 11, 23, 33: trench gate structure
- 12, 40: side wall
- 13, 29, 39: bottom wall
- 14: n-source region

- 20: conventional IGBT
- 22, 32: passivation layer
- 24: insulating layer
- 25, 35: first region
- 26, 36: second region
- 27, 37: third region
- 28, 38: remaining region

- 70 - 72: steps

- 80: power module

- 100: first curve
- 200: second curve
- 210: peak of the second curve

## Claims

1. A semiconductor device with an insulated gate comprising:
- a gate contact (9), wherein the gate contact (9) is formed as a trench gate structure (11, 33); and
- a semiconductor body (2, 31), on which the gate contact (9) is arranged;
wherein the gate contact (9) is at least partially embedded in a non-linear dielectric layer (10, 34).

2. The semiconductor device with the insulated gate according to claim 1, wherein, in the non-linear dielectric layer (10, 34), the electric dipolar moment per unit volume has a non-linear dependence on an electric field.

3. The semiconductor device with the insulated gate according to any one of claims 1 or 2, wherein
- the trench gate structure (11, 33) has a lateral side wall (12, 40), along which the gate contact (9) penetrates into the semiconductor body (2, 31), and a bottom wall (13, 39), which lies at an end of the trench gate structure (11, 33) inside the semiconductor body (2, 31); and
the non-linear dielectric layer (10, 34) has higher capacitive coupling properties in a region of the lateral side wall (12, 40) than in a region of the bottom wall (13, 39) .

4. The semiconductor device with the insulated gate according to any one of claims 1 to 3, wherein the gate contact (9) is at least partially electrically insulated, by the non-linear dielectric layer (10, 34), from the semiconductor body (2, 31) at least partially surrounding the gate contact (9).

5. The semiconductor device with the insulated gate according to any one of claims 1 to 4, wherein the non-linear dielectric layer (10, 34) comprises a material which is doped with at least one further material, to render the material of the non-linear dielectric layer (10, 34) ferroelectric.

6. The semiconductor device with the insulated gate according to claim 5, wherein the non-linear dielectric layer (10, 34) comprises hafnium dioxide (HfO₂), which is doped with zirconium dioxide (ZrO₂) and/or silicon (Si).

7. The semiconductor device with the insulated gate according to any one of claims 1 to 6, wherein a Curie temperature of the non-linear dielectric layer (10, 34) is lower than an operating temperature of the semiconductor device.

8. The semiconductor device with the insulated gate according to any one of claims 1 to 7, wherein a thickness of the non-linear dielectric layer (10, 34) lies between 1 nanometer and 100 nanometers.

9. The semiconductor device with the insulated gate according to any one of claims 1 to 8, wherein the semiconductor device is a silicon trench insulated-gate bipolar transistor, IGBT, (1, 30, 81), a silicon carbide trench IGBT, or a silicon carbide trench metal-oxide-semiconductor field-effect transistor, MOSFET.

10. A method for manufacturing a semiconductor device with an insulated gate comprising:
- providing (70) a semiconductor wafer for the semiconductor device;
- arranging (72) a gate contact (9) on the semiconductor wafer, wherein the gate contact (9) is formed as a trench gate structure (11, 33) and the gate contact (9) is at least partially embedded in a non-linear dielectric layer (10, 34).

11. The method for manufacturing the semiconductor device with the insulated gate according to claim 10, further comprising the steps of:
- doping (71) a material with at least one further material to render the material ferroelectric, and forming the non-linear dielectric layer (10, 34) with said doped material.

12. The method for manufacturing the semiconductor device with the insulated gate according to claim 11, wherein at the step of doping (71), hafnium dioxide (HfO₂) is doped with zirconium dioxide (ZrO₂) and/or silicon (Si), and the non-linear dielectric layer (10, 34) is formed with said doped Hf O₂.

13. A power module (80) comprising a semiconductor device with an insulated gate, according to any one of claims 1 to 9.
